(19) Europäisches Patentamt
European Patent Office
Office européen des brevets

(11) **EP 4 333 017 A1**

(12) **EUROPEAN PATENT APPLICATION**
published in accordance with Art. 153(4) EPC

(43) Date of publication:
**06.03.2024 Bulletin 2024/10**

(21) Application number: **22795630.7**

(22) Date of filing: **19.04.2022**

(51) International Patent Classification (IPC):
**H01J 37/143** (2006.01)    **H01J 37/145** (2006.01)

(52) Cooperative Patent Classification (CPC):
**H01J 37/143; H01J 37/145**

(86) International application number:
**PCT/JP2022/018129**

(87) International publication number:
**WO 2022/230717 (03.11.2022 Gazette 2022/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.04.2021 JP 2021075751**

(71) Applicant: **NIKON CORPORATION
Minato-ku
Tokyo 108-6290 (JP)**

(72) Inventors:
• **GOTO, Takakuni
Tokyo 108-6290 (JP)**
• **ISHIKAWA, Motofusa
Tokyo 108-6290 (JP)**
• **OGASAWARA, Baku
Tokyo 108-6290 (JP)**
• **KUSU, Shunta
Tokyo 108-6290 (JP)**
• **KOMATSU, Yuta
Tokyo 108-6290 (JP)**
• **UCHIDA, Tomoya
Tokyo 108-6290 (JP)**

(74) Representative: **Hoffmann Eitle
Patent- und Rechtsanwälte PartmbB
Arabellastraße 30
81925 München (DE)**

(54) **CHARGED PARTICLE OPTICAL SYSTEM AND CHARGED PARTICLE APPARATUS**

(57)    A charged particle optical system includes a permanent magnetic lens disposed closer to an object than a central point between a charged particle beam source and the object in an optical axis direction of the charged particle optical system, an electromagnetic lens disposed such that a position of at least a part of the electromagnetic lens overlaps the permanent magnetic lens in the optical axis direction of the charged particle optical system, and an electrostatic lens disposed such that a position of at least a part of the electrostatic lens overlaps at least one of the permanent magnetic lens and the electromagnetic lens in the optical axis direction of the charged particle optical system.

**EP 4 333 017 A1**

# FIG. 1

# Description

[Technical Field]

The present invention relates to a charged particle optical system and a charged particle apparatus.

Priority is claimed on Japanese Patent Application No. 2021-075751, filed April 28, 2021, the content of which is incorporated herein by reference.

[Background Art]

A charged particle apparatus and a charged particle optical system that are configured to control charged particles and irradiate a predetermined position of a target object with charged particle beams, are used (Patent Document 1).

[Citation List]

[Patent Document]

[Patent Document 1]
US Patent No. 9472372

[Summary of Invention]

[Solution to Problem]

A charged particle optical system according to a first aspect is a charged particle optical system configured to converge charged particle beams, which is emitted from a charged particle beam source, to an object, the charged particle optical system including: a permanent magnetic lens disposed closer to the object than a central point between the charged particle beam source and the object in an optical axis direction of the charged particle optical system; an electromagnetic lens disposed such that a position of at least a part of the electromagnetic lens overlaps the permanent magnetic lens in the optical axis direction of the charged particle optical system; and an electrostatic lens disposed such that a position of at least a part of the electrostatic lens overlaps at least one of the permanent magnetic lens and the electromagnetic lens in the optical axis direction of the charged particle optical system.

A charged particle optical system according to a second aspect is a charged particle optical system configured to converge charged particle beams, which is emitted from a charged particle beam source, to an object, the charged particle optical system including: a permanent magnetic lens configured to form a magnetic field parallel to an optical axis of the charged particle optical system in a first region; an electromagnetic lens configured to form a magnetic field parallel to the optical axis of the charged particle optical system and an electron beam trajectory in a second region; and an electrostatic lens configured to form an electrostatic lens field coaxial with the optical axis of the charged particle optical system in a third region, wherein at least some of the first region, the second region, and the third region overlap each other in an optical axis direction of the charged particle optical system.

A charged particle apparatus according to a third aspect includes a deflector configured to deflect the charged particle beam and change a position in the object where the object is irradiated with the charged particle beam in a direction crossing the optical axis of the charged particle optical system in the charged particle optical system according to the first or second aspect, the deflector includes a charged particle optical system disposed closer to the object than the electrostatic lens in the optical axis direction of the charged particle optical system, and a controller configured to control the electromagnetic lens, the electrostatic lens and the deflector, the deflector is able to change a position in the object where the object is irradiated with the charged particle beam in a first direction and a second direction that cross the optical axis, wherein the controller changes a focus of the charged particle beam by the electromagnetic lens according to a distance in which the position in the object where the object is irradiated with the charged particle beam is changed in the first direction, and wherein the controller changes the focus of the charged particle beam by the electrostatic lens according to a distance in which the position in the object where the object is irradiated with the charged particle beam is changed in the second direction, and wherein the distance in which the position in the object where the object is irradiated with the charged particle beam is changed in the first direction is greater than the distance in which the position in the object where the object is irradiated with the charged particle beam is changed in the second direction.

A charged particle optical system according to a fourth aspect is a charged particle optical system configured to converge charged particle beams, which is emitted from a charged particle beam source, to an object, the charged particle optical system including: a first electron optical system configured to control a current density distribution of the charged particle beam; and a second electron optical system configured to converge charged particle beams from the first electron optical system to the object, wherein the first electron optical system provides a magnetic field to charged particle beam passing through the first electron optical system so that a current density distribution of the charged particle beam entering the second electron optical system in a plane perpendicular to the optical axis is increased in an outer region which is outside of an inner region including the optical axis.

[Brief Description of Drawings]

FIG. 1 is a cross-sectional view showing a configuration of a charged particle apparatus of a first embodiment.

FIG. 2 is an enlarged cross-sectional view showing a configuration of an aperture member included in the charged particle apparatus of the first embodiment.

FIG. 3 is an enlarged cross-sectional view showing the vicinity of a second lens included in the charged particle apparatus of the first embodiment.

FIG. 4 is a view for describing a case in which it is assumed that a current distribution in a charged particle beam is a distribution of current flowing through an elliptic cylinder PP1.

FIG. 5 is a perspective view showing a configuration of a charged particle apparatus of a second embodiment.

FIG. 6 is a cross-sectional view showing a configuration of a charged particle apparatus of a third embodiment.

[Description of Embodiments]

(Charged particle apparatus and charged particle optical system of first embodiment)

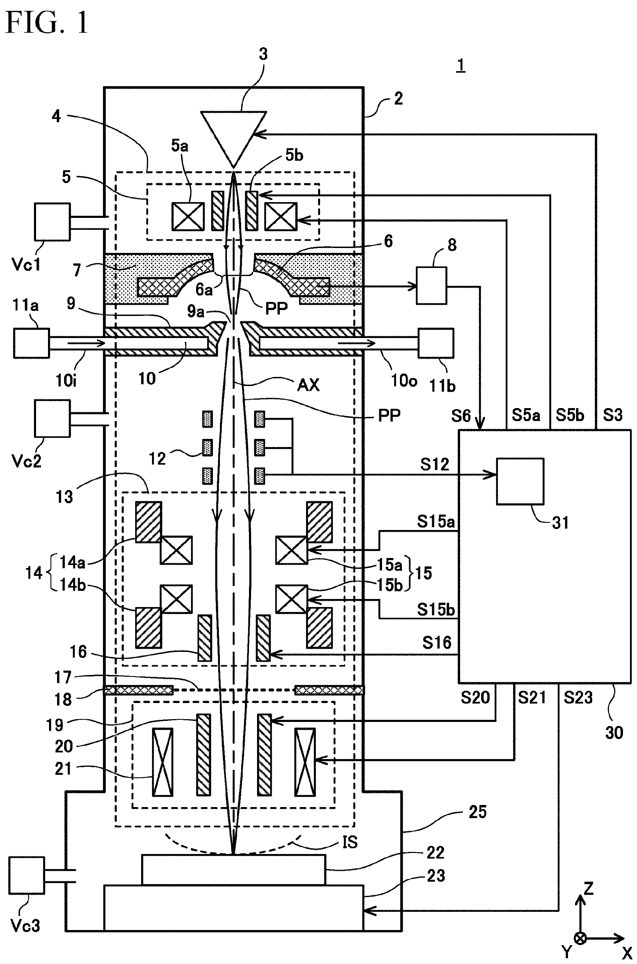

Hereinafter, a charged particle apparatus 1 and a charged particle optical system 4 of a first embodiment will be described with reference to FIG. 1 to FIG. 3. FIG. 1 is a cross-sectional view showing the charged particle apparatus 1 of the first embodiment.

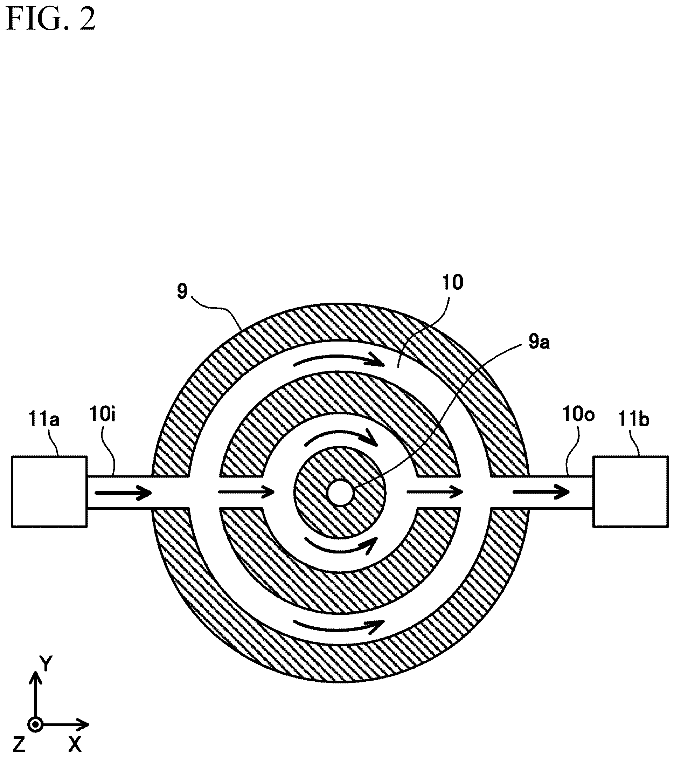

In an X direction, a Y direction, and a Z direction shown by arrows in FIG. 1, directions shown by the arrows are + directions. The X direction, the Y direction, and the Z direction are directions perpendicular to each other. In addition, an X direction, a Y direction, and a Z direction shown by arrows in each drawing from FIG. 2 show the same directions as the X direction, the Y direction, and the Z direction shown in FIG. 1, respectively.

The charged particle apparatus 1 has a lens barrel 2 and a chamber 25 that are partition walls configured to maintain a vacuum inside them. The lens barrel 2 has a substantially cylindrical shape extending in the Z direction as an example, and the chamber 25 has a substantially rectangular parallelepiped shape having sides parallel to the X direction, the Y direction and the Z direction as an example.

The charged particle optical system 4 is mainly provided in the lens barrel 2. The charged particle optical system 4 converges elementary particles or ions (hereinafter, generally referred to as "charged particles") such as electrons or the like emitted from a charged particle beam source 3 such as an electron gun or the like provided in the vicinity of an end portion in the lens barrel 2 in the +Z direction and irradiates a surface of a target object 22 disposed on a sampling stage 23 provided in the chamber 25 with the converged particles. The target object 22 is an object irradiated with the charged particles.

An optical axis AX of the charged particle optical system 4 is set parallel to the Z direction as an example. The charged particle optical system 4 includes a first lens part 5, a detection part 6, an aperture member 9, a magnetic detector 12, a second lens part 13, a conductive film 17, and a second deflection part 19 provided along the optical axis AX in sequence from the side of the charged particle beam source 3. The target object 22 is irradiated with a charged particle beam PP such as electrons or the like emitted from the charged particle beam source 3 through the vicinity of the optical axis AX. The sampling stage 23 may include a stage mechanism configured to move the target object 22 in the X direction and the Y direction on the basis of a control signal S23 from a controller 30. Here, the first lens part 5 and the second lens part 13 may be electron lenses.

Further, details of the conductive film 17 will be described below.

In addition, the charged particle beam PP in the drawings shows a substantially outer edge of a route through which a charged particle passes.

The charged particle apparatus 1 includes an exhaust system such as a vacuum pump or the like configured to exhaust the inside of the lens barrel 2 and the chamber 25 and reduces a pressure. For example, an exhaust system Vc1 is provided closer to the charged particle beam source 3 than the aperture member 9 of the lens barrel 2, and an exhaust system Vc2 is provided between the aperture member 9 of the lens barrel 2 and the conductive film 17. In addition, an exhaust system Vc3 is provided in the chamber 25, and the exhaust system Vc3 exhausts the inside of the chamber 25 and a space of the lens barrel 2 which is closer to the sampling stage 23 than the conductive film 17.

In general, it is difficult to maintain a high vacuum state in the space in the chamber 25 where the target object 22 is placed due to outgas or the like from the target object 22. The aperture member 9 and the conductive film 17 also function as a socalled gas top to maintain a higher vacuum in the vicinity of the charged particle beam source 3 located on the +Z side of the lens barrel 2 than in the chamber 25. That is, the aperture member 9 can allow a space in the lens barrel 2 closer to the charged particle beam source 3 than the aperture member 9 to have a higher vacuum (lower atmospheric pressure) than the space in the lens barrel 2 closer to the sampling stage 23 than the aperture member 9. In addition, the conductive film 17 can allow a space in the lens barrel 2 closer to the charged particle beam source 3 than the conductive film 17 to have a higher vacuum (lower atmospheric pressure) that in the space closer to the sampling stage 23 than the conductive film 17.

The above-mentioned exhaust systems Vc1 to Vc3 have each an exhaust capacity that is set such that the atmospheric pressure of the space that is exhausted satisfies the above-mentioned relationship.

Further, an aperture member may be provided at the position of the conductive film 17 or in the vicinity of the position of the conductive film 17 without providing the conductive film 17. Even in this case, the space closer to the charged particle beam source 3 than the aperture member can be made to have a higher vacuum (lower the atmospheric pressure) that in the space closer to the sampling stage 23 than the aperture member.

The charged particle beams PP such as electrons or the like emitted from the charged particle beam source 3 according to a control signal S3 from the controller 30 is converged by the first lens part 5, and passes through a transmission part 6a formed to coincide with the optical axis AX at substantially a center of the detection part 6. Most of the charged particles passing through the transmission part 6a pass through an opening 9a formed to coincide with the optical axis AX at substantially a center of the aperture member 9. Meanwhile, some of the charged particles passing through the transmission part 6a collide with the aperture member 9 so as to be reflected and scattered, or generate secondary electrons. Then, the reflected or scattered charged particles or secondary electrons enter the detection part 6 disposed on the charged particle beam source 3 side of the aperture member 9.

The first lens part 5 has a first magnetic lens 5a constituted by a coil or the like configured to converge the charged particle beam PP, and a first deflection part 5b configured to deflect charged particles such that most of the charged particles pass through the opening 9a. The first deflection part 5b may be an electrostatic deflector in which a plurality of electrodes are disposed about the optical axis AX, or may be a magnetic deflector in which a plurality of coils are disposed about the optical axis AX. The first deflection part 5b may include both an electrostatic deflector and a magnetic deflector.

A control signal S5a is input from the controller 30 to the first magnetic lens 5a, and a control signal S5b is input from the controller 30 to the first deflection part 5b.

When a state of deflection of charged particles due to the first deflection part 5b is fixed, an amount of charged particles reflected by the aperture member 9 and entering the detection part 6 is proportional to an amount of charged particles passing through the aperture member 9. Accordingly, the amount of charged particles passing through the aperture member 9 can be measured by measuring the amount of charged particles entering the detection part 6, i.e., the amount of electric charge entering the detection part 6.

The amount of electric charges entering the detection part 6 is measured by an electric charge measuring instrument 8, and a signal S6 related to the measured electric charge is transmitted to the controller 30.

As described above, the configuration of the charged particle optical system 4 and the charged particle apparatus 1 can be simplified by using the aperture member 9 functioning as a gas top as a member configured to measure an amount of charged particles.

An insulating member 7 covers the detection part 6 against the charged particle beam PP in order to accurately measure the amount of electric charge of the charged particles reflected by the aperture member 9 and entering the detection part 6, and electrically separates the detection part 6 from the aperture member 9. While FIG. 1 shows an example in which the insulating member 7 holding the detection part 6 is provided in contact with the lens barrel 2, the insulating member 7 may be provided in contact with the aperture member 9.

Since some of the charged particles collide with the aperture member 9, the aperture member 9 is heated by energy of the charged particles. Here, in the aperture member 9, a flow channel 10 through which a cooling fluid flows is provided, and a supply system 11 (11a, 11b) configured to supply the cooling fluid to the flow channel 10 is provided. A cooling medium such as a liquid or the like that cools the aperture member 9 is supplied to the flow channel 10 from a supply side 11a, and collected at a collection side 11b after flowing through the aperture member 9. The supply system 11 is a general term for the supply side 11a and the collection side 11b.

Further, when measuring the amount of charged particles colliding with the aperture member 9, it is also possible to measure the amount of electric charge of the aperture member 9 itself. However, since the aperture member 9 is heated by collision with the charged particles as described above, it is desirably cooled by the coolant such as a liquid or the like as described above. In this case, since some of the electric charge accumulated in the aperture member 9 is conducted to the outside via the coolant, even if the amount of electric charge of the aperture member 9 itself is measured, it is difficult to accurately measure the amount of electric charge.

Meanwhile, as described above, when the electric charges reflected by the aperture member 9 and accumulated in the detection part 6 are measured, since there is no fear of electrical conduction due to the coolant or the like, it is possible to accurately measure the electric charge, that is, the amount of charged particles passing through the aperture member 9.

FIG. 2 is a view showing an example of the flow channel 10 in the aperture member 9 and a cross-sectional view in an XY plane at substantially a center position of the aperture member 9 in the Z direction. A plurality of substantially annular flow channels 10 are formed in the aperture member 9 in a substantially coaxial shape. The cooling medium supplied from the supply side 11a of the supply system 11 via an inflow pipe 10i is discharged to the collection side 11b via an outflow pipe 10o after flowing through the substantially annular flow channel 10. The cooling medium collected at the collection side 11b may be supplied to the supply side 11a again after the temperature is adjusted.

The charged particle beam PP passing through the opening 9a of the aperture member 9 passes through the vicinity of the magnetic detector 12 and enters the second lens part 13. Details of the magnetic detector 12 will be described below.

The second lens part 13 has a permanent magnetic lens 14, an electromagnetic lens 15, and an electrostatic lens 16, each having a substantially cylindrical shape which is hollow inside, and center axes which are substantially coinciding with the optical axis AX of the charged particle optical system 4.

Among these, the permanent magnetic lens 14 includes a permanent magnet, and is disposed closer to the target object 22 than a central point between the charged particle beam source 3 and the target object 22 in the optical axis AX direction of the charged particle optical system 4. The permanent magnetic lens 14 forms a magnetic field on the optical axis AX in parallel with the Z direction. For example, as shown in FIG. 1, the permanent magnetic lens 14 is a first compound lens including two permanent magnets 14a and 14b separated in the Z direction. The two permanent magnets 14a and 14b form magnetic fields parallel to the Z direction and in opposite directions on the optical axis AX.

The electromagnetic lens 15 includes an electromagnet such as a coil or the like, and is disposed so that at least a part of the position of the charged particle optical system 4 in the optical axis AX direction overlaps the permanent magnetic lens 14. The electromagnetic lens 15 forms a magnetic field on the optical axis AX in parallel with the Z direction. For example, as shown in FIG. 1, the electromagnetic lens 15 is a second compound lens including two electromagnets 15a and 15b separated in the Z direction. The two electromagnets 15a and 15b form magnetic fields parallel to the Z direction and in opposite directions on the optical axis AX.

For example, the electromagnetic lens 15 is disposed between two permanent magnets 14a and 14b included in the permanent magnetic lens 14 in the optical axis AX direction.

In addition, a center of the above-mentioned second compound lens (the electromagnets 15a and 15b) may coincide with a center of the above-mentioned first compound lens (the permanent magnets 14a and 14b).

Further, the electrostatic lens 16 may be disposed closer to the target object 22 than the center of the above-mentioned second compound lens (the electromagnets 15a and 15b) in the optical axis AX direction.

The currents flowing through the electromagnets 15a and 15b are controlled by control signals S15a and S15b from the controller 30, respectively, and thus, intensity of the magnetic field formed on the optical axis AX or the like is controlled.

Further, the two electromagnets 15a and 15b may have a yoke containing a magnetic material arranged around a coil.

The electrostatic lens 16 is a conductor such as a metal or the like having a substantially cylindrical shape which is hollow inside, and at least one of the permanent magnetic lens 14 and the electromagnetic lens 15 is disposed so as to overlap with the electrostatic lens 16 at least a partial position in the optical axis AX direction of the charged particle optical system 4. The electric potential of the electrostatic lens 16 is controlled by a control signal S16 from the controller 30, and thus, an electric potential on the optical axis AX or the like is controlled.

As an example, the charged particle beams PP is diverged with respect to the optical axis AX at a side closer to the charged particle beam source 3 than the permanent magnetic lens 14, and the permanent magnetic lens 14 causes the charged particle beam PP to be converged with respect to the optical axis AX of the charged particle optical system 4 at a side closer to the object (the target object 22).

Alternatively, another magnetic lens is provided closer to the charged particle beam source 3 than the permanent magnetic lens 14, i.e., on the side of the aperture member 9, and the charged particle beam PP that enters the permanent magnetic lens 14 may be used as a convergence beam by the other magnetic lens.

In addition, the permanent magnetic lens 14 may be disposed in the vicinity of the pupil surface of the charged particle optical system 4.

Further, in FIG. 1, while the permanent magnetic lens 14 and the electromagnetic lens 15 are disposed at positions farther from the optical axis AX than the electrostatic lens 16, at least one of the permanent magnetic lens 14 and the electromagnetic lens 15 may be disposed at apposition closer to the optical axis AX than the electrostatic lens 16.

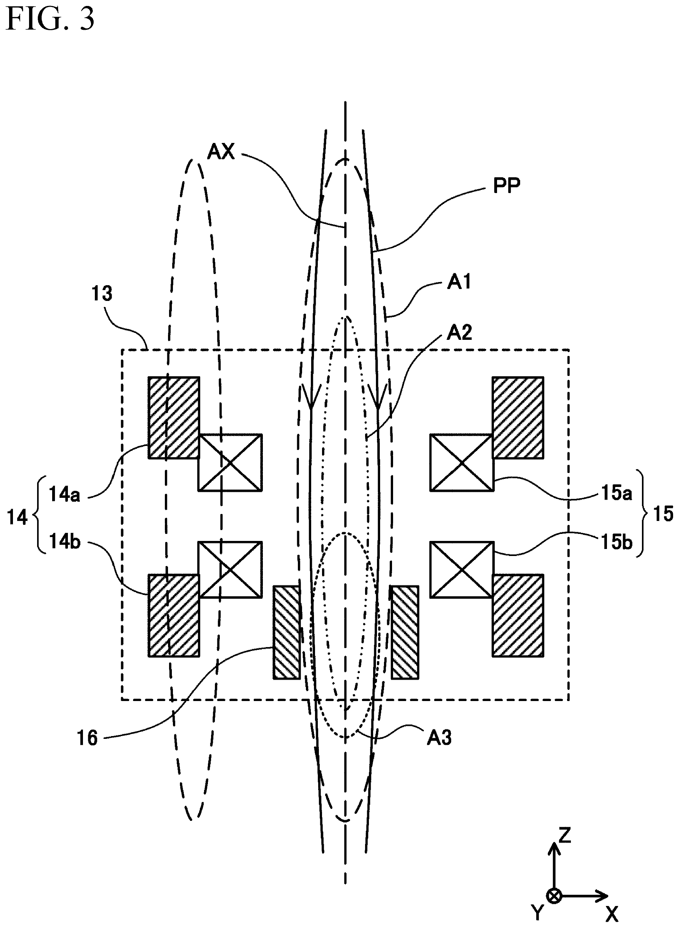

FIG. 3 is an enlarged cross-sectional view showing the vicinity of a portion of the second lens part 13 of the charged particle optical system 4. The permanent magnetic lens 14 forms a magnetic field parallel to the optical axis AX in a first region A1, and the electromagnetic lens 15 forms a magnetic field parallel to the optical axis AX in a second region A2. Meanwhile, the electrostatic lens 16 forms an electrostatic lens field (electric field) coaxial with the optical axis AX in a third region A3. Then, at least some of the first region A1, the second region A2, and the third region A3 overlap each other in a direction of the optical axis AX.

The controller 30 controls the current flowing through the electromagnetic lens 15 and controls a magnetic field of a region in which the second region A2 overlaps the first region A1 or the third region A3 such that a position of the target object 22 irradiated with the charged particle beam PP is positioned within a focus depth of the charged particle beam PP.

In the charged particle optical system 4 and the charged particle apparatus 1 of the embodiment, the controller 30 further controls a voltage applied to the electrostatic lens 16. Accordingly, a position where a convergence action by the electrostatic lens 16 is controlled and the target object 22 is irradiated with the charged particle beam PP becomes a position within a focus depth of the charged particle beam PP.

The charged particle beam PP passing through the second lens part 13 passes through the conductive film 17 and reaches the second deflection part 19.

The conductive film 17 is a membrane through which a charged particle such as an electron or the like, and for example, like graphene, a membrane in which carbons are combined and formed in a secondary original form can be used.

The second deflection part 19 includes at least one of a second electrostatic deflector 20 in which a plurality of electrodes are disposed about the optical axis AX, and a second magnetic deflector 21 in which a plurality of coils are disposed about the optical axis AX.

As shown in FIG. 1, the second electrostatic deflector 20 and the second magnetic deflector 21 are disposed closer to the target object 22 than the electrostatic lens 16 along the optical axis AX.

The controller 30 controls the second electrostatic deflector 20 or the second magnetic deflector 21 in the second deflection part 19 according to a control signal S20 or a control signal S21, and deflects the charged particle beam PP in the X direction and the Y direction. Accordingly, the charged particle beam PP can be irradiated over a wide range on the target object 22.

Like a general charged particle optical system, even in the charged particle optical system 4 of the embodiment, a convergence position (focal position) of the charged particle beam PP is changed in the Z direction due to deflection of the charged particle beam PP. The change in the focal position when the charged particle beam PP is deflected while a convergence force of the second lens part 13 is fixed is shown by a broken line as a field curvature IS.

Accordingly, along with the deflection of the charged particle beam PP, it is necessary to change the convergence force of the second lens part 13.

In the charged particle optical system 4 and the charged particle apparatus 1 of the embodiment, a function as a convergence lens configured to converge the charged particle beam PP is mainly exhibited by the permanent magnetic lens 14. Meanwhile, the electromagnetic lens 15 can change the convergence position (focus) of the charged particle beam PP in the optical axis AX direction in the target object 22 with a large stroke as the controller 30 controls the current flowing through the electromagnetic lens 15.

However, when another magnetic material such as the lens barrel 2, the permanent magnetic lens 14, or the like, is present in the vicinity of the electromagnetic lens 15, due to an influence such as inductance, eddy current loss, or the like, caused by the magnetic material, it is difficult to change the magnetic field formed by the electromagnetic lens 15 at high speed. For this reason, with only the electromagnetic lens 15, it is difficult to change the position of the focus of the charged particle beam PP in the optical axis AX direction at high speed.

In the charged particle optical system 4 and the charged particle apparatus 1 of the embodiment, since the electrostatic lens 16 is further provided, by controlling the electric potential of the electrostatic lens 16, even if the other magnetic material is present in the vicinity, the focus position of the charged particle beam PP can be changed at high speed in the optical axis AX direction. Accordingly, in the charged particle optical system 4 and the charged particle apparatus 1 of the embodiment, even if the charged particle beam PP is deflected at high speed, the charged particle beam PP can be accurately focused and irradiated over the wide range on the target object 22.

In addition, in the charged particle optical system 4 and the charged particle apparatus 1 of the embodiment, in controlling of the focal position of the charged particle beam PP in the optical axis AX direction, since it becomes less affected by other magnetic materials in the vicinity of the electromagnetic lens 15, the lens barrel 2 can be made thinner, that is, smaller.

Further, as described above, the electrostatic lens 16 is a conductor such as a metal or the like having a substantially cylindrical shape which is hollow inside, i.e., having a columnar internal space which is substantially parallel to the optical axis AX and in which a center of the columnar internal space substantially coincides with the optical axis AX. For example, a ratio between the length in the optical axis AX direction and the inner diameter of the internal space surrounded by the conductor such as a metal or the like may be set to 1.67 or more. In this case, the focal position of the charged particle beam PP can be changed in the optical axis AX direction at higher speed.

Depending on the shape or the like of the target object 22, a distance at which the charged particle beam PP should be deflected on the target object 22 in the X direction (first direction) may be larger than a distance at which the charged particle beam PP should be deflected in the Y direction (second direction). In this case, the electromagnetic lens 15 may be controlled on the basis of the deflection distance of the charged particle beam PP in the X direction, and the electrostatic lens 16 may be controlled on the basis of the deflection distance of the charged particle beam PP in the Y direction to control the focal position of the charged particle beam PP.

Deflection in the X direction, where the distance to be deflected is long, requires focus adjustment of a larger stroke. Here, by performing correction using the electromagnetic lens 15 with a large correction stroke at the focal position, it is possible to correct a deviation of a focal position in the optical axis AX direction caused by deflection in the X direction within a wide range.

Hereinafter, the magnetic detector 12 will be described. For example, the magnetic detector 12 includes a magneto-impedance element, and a plurality of detection surfaces of the magnetic detector 12 are disposed along the optical axis AX of the charged particle optical system 4 configured to converge the charged particle beams PP emitted from the charged particle beam source 3 to the target object 22. Then, detection values detected by the plurality of magnetic detectors 12 are sent to a calculation part 31 in the controller 30, and the calculation part 31 calculates information related to the optical axis AX and the charged particle beams PP flowing in the vicinity of the optical axis AX on the basis of the detection value.

The plurality of magnetic detectors 12 detect (measure) magnetic fields at places where they are disposed, respectively. By disposing the magnetic detector 12 in the vicinity of the route of the charged particle beam PP, the magnetic field formed by the charged particle beam PP as the current can be detected by the magnetic detector 12. Then, by disposing the plurality of magnetic detectors 12 in the vicinity of the route of the charged particle beam PP, it is possible to calculate a current of the charged particle beam, a shift of the charged particle beam position, an advance azimuth of the charged particle beam, a rotation angle of the charged particle beam, an aspect ratio of the charged particle beam, and the like, on the basis of the value of the magnetic field measured by each of the magnetic detectors 12.

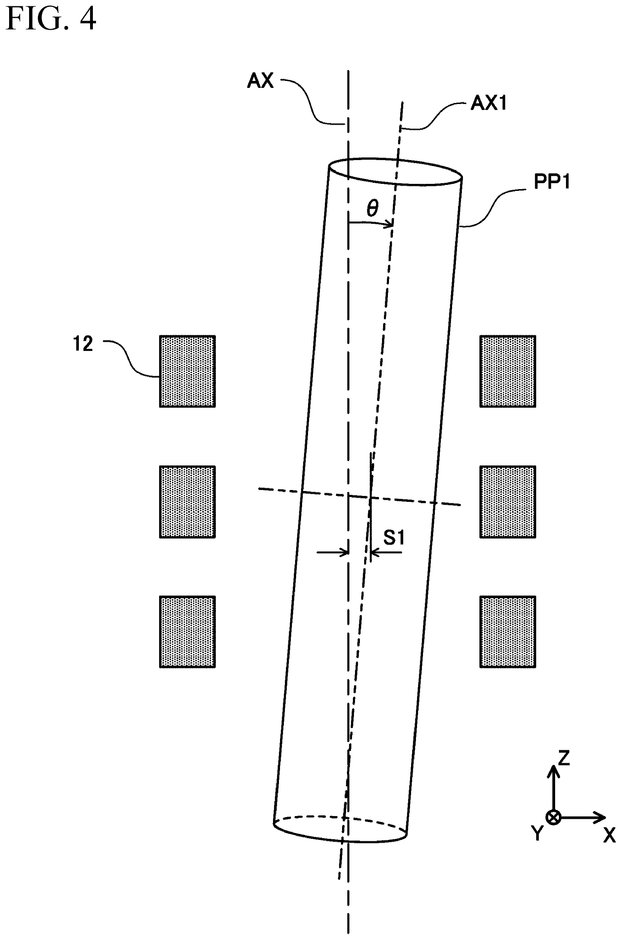

As an example of a calculation method, FIG. 4 is a view for describing a case in which it is assumed that a current distribution in the charged particle beam PP within a predetermined range in the Z direction (the optical axis AX direction) is a distribution of a current flowing through an elliptic cylinder PP1 in which a direction of a center axis AX1 of the elliptic cylinder PP1 substantially coincides with the optical axis AX direction. It is assumed that the direction of the center axis AX1 of the elliptic cylinder PP1 is deviated by a deflection angle $\theta$ from the optical axis AX (Z direction) and a deflection angle $\varphi$ (not shown) from the X direction.

When the current (charged particle) flows through the elliptic cylinder PP1, the current flowing through each portion of the inside of the elliptic cylinder PP1 forms a magnetic field at each of the positions of the plurality of magnetic detectors 12 disposed therearound on the basis of a Biot-Savart law. On the other way around, the magnetic field formed at each position of the plurality of magnetic detectors 12 is the sum of the magnetic fields formed by the current flowing through each portion inside the elliptic cylinder PP1 on the basis of the Biot-Savart law.

The calculation part 31 performs statistical processing such as a least squares method or the like on the basis of the magnetic field detected (measured) by each of the plurality of magnetic detectors 12. Accordingly, the calculation part 31 calculates information related to the charged particle density distribution (current density) of the charged particle beam PP related to the direction crossing the optical axis AX, for example, a shift amount S1 or the like from the optical axis AX in the XY direction of the elliptic cylinder PP1. In addition, the calculation part 31 calculates information related to the deviation angle from the optical axis AX in a direction of advance of the charged particle beam PP of the above-mentioned deflection angle $\theta$, deflection angle $\varphi$, and the like, of the elliptic cylinder PP1 by the above-mentioned statistical processing.

Further, the magnetic detector 12 measures not only a magnetic field formed by the charged particle beam PP but also a magnetic field formed by the terrestrial magnetism, the permanent magnetic lens 14, or the electromagnetic lens 15. Accordingly, measurement of the magnetic field by the magnetic detector 12 may employ a difference between the measured values in both cases in which the charged particle beam PP is emitted from the charged particle beam source 3 and not emitted therefrom.

Further, the controller 30 may control the charged particle beam source 3 to emit the charged particles in pulses at a predetermined frequency, and the calculation part 31 may calculate information related to the charged particle beam PP on the basis of an element of the detection value of the magnetic detector 12 in synchronization with the predetermined frequency. This configuration also makes it possible to eliminate the influence of the magnetic field such as the terrestrial magnetism or the like.

At least some of the plurality of magnetic detectors 12 may be disposed at different positions related to the optical axis AX direction. Accordingly, the information related to the charged particle beam PP can be obtained with high accuracy.

In addition, a configuration may also be adopted in which no magnetic material with a relative permeability of 2 or more is placed within a range of 5 times the distance from the optical axis AX to each of the magnetic detectors 12, centering on each of the plurality of magnetic detectors 12. According to this configuration, it is possible to reduce the bad influence of the disturbance of the magnetic field caused by the magnetic material in the magnetic detector 12, and it is also possible to obtain information related to the charged particle beam PP with higher accuracy.

(Effects of charged particle optical system and charged particle apparatus of first embodiment)

(1) According to a first viewpoint, the charged particle optical system 4 of the first embodiment is the charged particle optical system 4 configured to converge the charged particle beam PP, which is emitted from the charged particle beam source 3, to the object (the target object 22), and includes the permanent magnetic lens 14 disposed closer to the object than the central point between the charged particle beam source 3 and the object (the target object 22) in the optical axis AX direction of the charged particle optical system 4, the electromagnetic lens 15 disposed such that at least a partial position overlaps the permanent magnetic lens 14 in the optical axis AX direction of the charged particle optical system 4, and the electrostatic lens 16 disposed such that at least a partial position overlaps at least one of the permanent magnetic lens 14 and the electromagnetic lens 15 in the optical axis AX direction of the charged particle optical system 4.

According to this configuration, in addition to the permanent magnetic lens 14 functioning as the convergence lens configured to converge the charged particle beams PP, the electromagnetic lens 15 can change the convergence position (focus) of the charged particle beam PP in the object (the target object 22) in the optical axis AX direction with a large stroke. That is, the charged particle beams PP can be focused over the wide range in the optical axis AX direction. Further, by controlling the electric potential of the electrostatic lens 16, the position of the focus of the charged particle beam PP can be changed in the optical axis AX direction at high speed.

Accordingly, in the charged particle optical system 4 of the embodiment, even when the charged particle beam PP is deflected at high speed, the charged particle beam PP can be accurately focused and irradiated over the wide range on the target object 22.

In addition, in the charged particle optical system 4 of the embodiment, in controlling of the focal position of the charged particle beam PP in the optical axis AX direction, since it becomes less susceptible to the influence of other magnetic materials in the vicinity of the electromagnetic lens 15, it is possible to make the charged particle optical system 4 thinner, i.e., reduce size.

Further, in the charged particle optical system 4 having the effects of the above-mentioned (1), at least some of the first lens part 5, the aperture member 9, the detection part 6, the electric charge measuring instrument 8, the insulating member 7, the magnetic detector 12, and the calculation part 31, which are above-mentioned, do not necessarily have to be provided.

(2) According to a second viewpoint, the charged particle optical system 4 of the first embodiment is the charged particle optical system 4 configured to converge the charged particle beams PP, which is emitted from the charged particle beam source 3, to the object (the target object 22), and includes the permanent magnetic lens 14 configured to form a magnetic field parallel to the optical axis AX of the charged particle optical system 4 in the first region A1, the electromagnetic lens 15 configured to form a magnetic field parallel to the optical axis AX of the charged particle optical system 4 in the second region A2, and the electrostatic lens 16 configured to form an electrostatic lens field coaxial with the optical axis AX of the charged particle optical system 4 in the third region A3, at least some of the first region A1, the second region A2, and the third region A3 overlapping each other in the optical axis AX direction of the charged particle optical system 4.

According to this configuration, in addition to the permanent magnetic lens 14 functioning as the convergence lens configured to converge the charged particle beam PP, the electromagnetic lens 15 can change the convergence position (focus) of the charged particle beam PP in the optical axis AX direction in the object (the target object 22) with a large stroke. That is, the charged particle beams PP can be focused over the wide range in the optical axis AX direction. Further, by controlling the electric potential of the electrostatic lens 16, the position of the focus of the charged particle beam PP can be changed in the optical axis AX direction at high speed.

Further, in the charged particle optical system 4 having the effects of the above-mentioned (2), at least some of the first lens part 5, the aperture member 9, the detection part 6, the electric charge measuring instrument 8, the insulating member 7, the magnetic detector 12, and the calculation part 31, which are above-mentioned, do not necessarily have to be provided.

(3) According to a third viewpoint, the charged particle apparatus 1 of the first embodiment includes the plurality of magnetic detectors 12 disposed along the optical axis AX of the charged particle optical system 4 configured to converge the charged particle beams PP, which is emitted from the charged particle beam source 3, to the object (the target object 22), and the calculation part 31 configured to calculate information related to the charged particle beam PP flowing through the optical axis AX and the vicinity of the optical axis AX on the basis of the detection value of each of the plurality of magnetic detectors 12.

According to this configuration, the information related to the charged particle beam PP such as the shift amount S1 of the charged particle beam PP from the optical axis AX, the deflection angle $\theta$ and the deflection angle $\varphi$ with respect to the optical axis AX, and the like can be obtained without direct insertion of the detector with respect to the charged particle beam PP. For this reason, even in a situation in which irradiation of the object (the target object 22) with the charged particle beam PP is necessary, the information related to the charged particle beam PP can be obtained without damage to the charged particle beam PP.

Further, in the charged particle apparatus 1 having the effects of the above-mentioned (3), at least some of the first lens part 5, the aperture member 9, the detection part 6, the electric charge measuring instrument 8, the insulating member 7, the second lens part 13, and the second deflection part 19, which are above-mentioned, do not necessarily have to be provided.

(4) According to a fourth viewpoint, the charged particle optical system 4 of the first embodiment is the charged particle optical system 4 configured to converge the charged particle beams PP, which is emitted from the charged particle beam source 3, to the object (the target object 22), and includes the aperture member 9 provided between a space that has the opening 9a through which the charged particle beam PP can pass and that is disposed closer to the charged particle beam source 3 than the opening 9a and a space that is opposite to the charged particle beam source 3 than the opening 9a, and the detection part 6 that is disposed closer to the charged particle beam source 3 than the aperture member 9 and that is configured to detect an electron from the aperture member 9 irradiated with the charged particle beam PP.

According to this configuration, by using the aperture member 9, which also functions as a gas top, as a member that measures the amount of charged particles, the configuration of the charged particle optical system 4 can be simplified.

Further, in the charged particle apparatus 1 having the effects of the above-mentioned (4), at least some of the magnetic detector 12, the calculation part 31, the second lens part 13, and the second deflection part 19, which are above-mentioned, do not necessarily have to be provided.

(Second embodiment of charged particle apparatus)

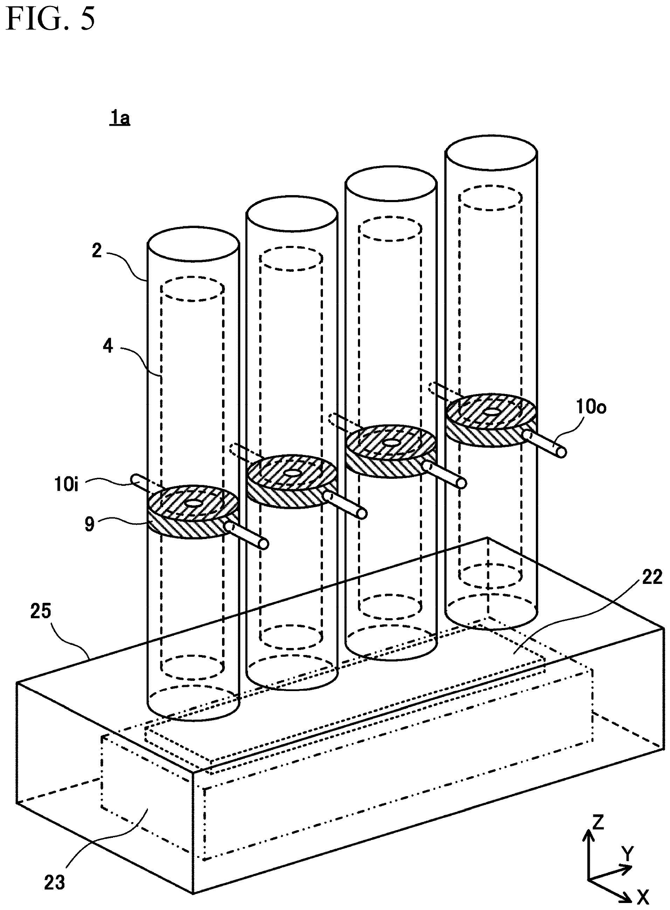

Hereinafter, a charged particle apparatus 1a of a second embodiment will be described with reference to FIG. 5. A configuration of the charged particle apparatus 1a of the second embodiment is mostly the same as the configuration of the charged particle apparatus 1 of the above-mentioned first embodiment. Accordingly, hereinafter, differences between the charged particle apparatus 1a of the second embodiment and the charged particle apparatus 1 of and the first embodiment will be described, and common configurations are designated by the same reference signs and descriptions thereof will be omitted as appropriate.

As shown in FIG. 5, the charged particle apparatus 1a of the second embodiment is distinguished from the charged particle apparatus 1 of the first embodiment in that it has a plurality of lens barrels 2 each including the charged particle optical system 4 of the first embodiment. For example, the plurality of lens barrels 2 are disposed in the Y direction in a row. All the plurality of lens barrels 2 are connected to the chamber 25 while maintaining airtightness. The sampling stage 23 is disposed in the chamber 25, and the sampling stage 23 has a stage mechanism configured to place the target object 22 and move the target object 22 in the X direction as an example.

The charged particle apparatus 1a of the second embodiment includes the plurality of lens barrels 2 arranged in the Y direction, and can irradiate a wide region of the target object 22 in the Y direction with the charged particle beams PP almost at once. In addition, as the target object 22 is moved in the X direction by the sampling stage 23, the wide region of the target object 22 in the X direction can also be irradiated with the charged particle beams PP.

As described above, since the charged particle optical system 4 includes the permanent magnetic lens 14, the electromagnetic lens 15, and the electrostatic lens 16, which have a predetermined arrangement relation, the outer diameter of the charged particle optical system 4 can be reduced. Accordingly, in the charged particle apparatus 1a of the second embodiment, the charged particle optical systems 4 can be arranged at short intervals in the Y direction, that is, densely.

Further, in order to more densely dispose the charged particle optical systems 4 in the Y direction, as shown in FIG. 4, the inflow pipe 10i and the outflow pipe 10o configured to supply a cooling medium to the flow channel 10 (not shown in FIG. 4) of the aperture member 9 may be disposed in a direction different from the Y direction. That is, the flow channel 10 of the aperture member 9 of each of the plurality of charged particle optical systems 4 may be configured to be supplied with a fluid (cooling medium) from a direction crossing the Y direction.

(Effects of charged particle apparatus of second embodiment)

(5) In the charged particle apparatus 1a of the second embodiment, in addition to the configuration of the charged particle apparatus 1 of the above-mentioned second embodiment, the aperture member 9 that constitutes the charged particle optical system 4 has the flow channel 10 and the plurality of charged particle optical systems 4 each including the supply system 11 configured to supply a temperature-adjusted fluid to the flow channel 10, the plurality of charged particle optical systems 4 are disposed in a first direction crossing the optical axis AX direction of the charged particle optical system 4, and the flow channel 10 of the aperture member 9 of each of the plurality of charged particle optical systems 4 is supplied with a fluid in a direction crossing the first direction.

According to this configuration, the charged particle optical systems 4 can be arranged at short intervals in the first direction, that is, densely arranged, and the aperture member 9 can be efficiently cooled. For this reason, it is possible to prevent the aperture member 9 from being heated and to stably operate the charged particle apparatus 1a.

Further, in the charged particle apparatus 1a having the effects of the above-mentioned (5), at least some of the magnetic detector 12, the calculation part 31, the second lens part 13, and the second deflection part 19, which are above-mentioned, do not necessarily have to be provided.

(Third embodiment of charged particle apparatus)

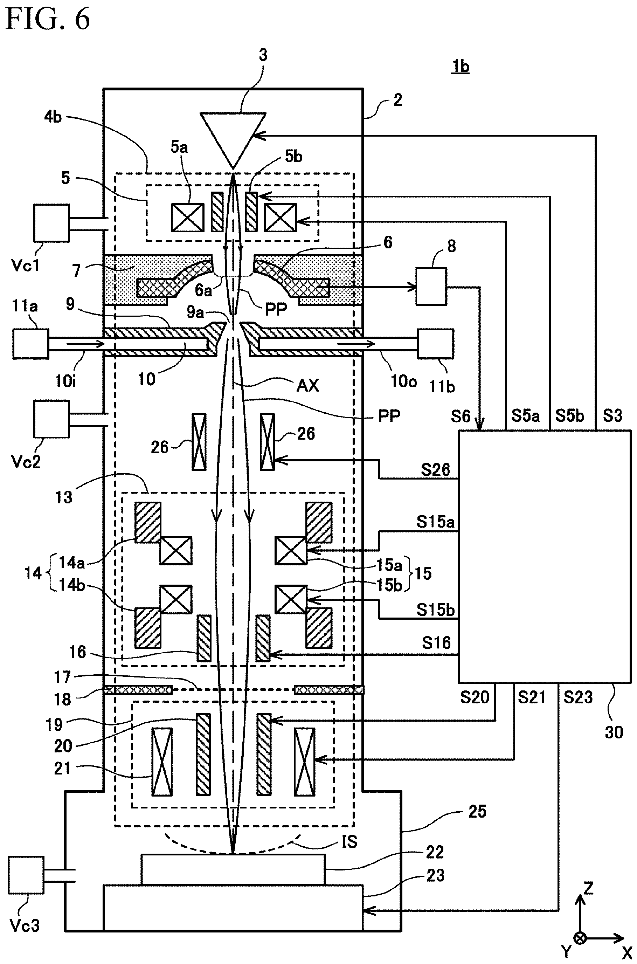

Hereinafter, a charged particle apparatus 1b of a third embodiment will be described with reference to FIG. 6. A configuration of the charged particle apparatus 1b of the third embodiment is mostly the same as the configuration of the charged particle apparatus 1 of the first embodiment described above. Accordingly, hereinafter, differences between the charged particle apparatus 1b of the third embodiment and the charged particle apparatus 1 of the first embodiment will be described, and common configurations are designated by the same reference sign and description thereof will be omitted as appropriate.

As shown in FIG. 6, the charged particle apparatus 1b of the third embodiment includes a charged particle optical system 4b having a configuration partially different from the charged particle optical system 4 included in the charged particle apparatus 1 of the first embodiment. The charged particle optical system 4b is distinguished from the charged particle optical system 4 in the charged particle apparatus 1 of the first embodiment in that a condenser lens part 26 is provided between the aperture member 9 and the second lens part 13.

The condenser lens part 26 may be an electron lens or may include a magnetic lens as an example. A control signal S26 from the controller 30 may be input to the condenser lens part 26.

The charged particle beam PP via the opening 9a of the aperture member 9 passes through the condenser lens part 26 and heads to the second lens part 13. Here, the charged particle beams PP heading toward the aperture member 9 are converged to the optical axis AX due to the action of the first lens part 5, and after forming a crossover or beam waist near the aperture member 9, becomes the divergence state with respect to the optical axis AX and heads toward the condenser lens part 26.

The condenser lens part 26 provides a divergence angle inhibitory action of a beam outer diameter to the charged particle beam PP passing therethrough, and also provides an exchange action of an internal current density of the charged particle beam PP. This exchange action of the internal current density occurs due to the interaction between a primary convergence action of the magnetic lens of the condenser lens part 26 and a non-linear space electric charge effect of the beam current density distribution of the charged particle beam PP.

As described above, while the charged particle beam PP passing through the condenser lens part 26 moves away from the vicinity of the optical axis AX due to its non-linear space electric charge effect, the charged particle beam PP receives the primary convergence action due to the condenser lens part 26 from the outside of the charged particle beam PP.

Accordingly, in the charged particle beam PP passing through the condenser lens part 26, the current density distribution in the vicinity of the optical axis AX of the charged particle optical system 4b is smaller than a current density of a peripheral portion (a portion separated from the optical axis AX in a direction perpendicular to the optical axis). Here, when it is only the space electric charge effect of the charged particle beam PP, a ratio of the distance from the optical axis AX of the region where the current density distribution becomes small with respect to a distance from the optical axis AX of the outer circumferential portion of the charged particle beam PP (hereinafter referred to as ring-belt ratio) does not change much. However, in the charged particle apparatus 1b of the third embodiment, since the condenser lens part 26 applies a magnetic field to the charged particle beam PP so that the outer circumference of the charged particle beam PP does not deviate too far from the optical axis, the ring-belt ratio can be increased. That is, a rate of beam hollowing can be increased.

Here, the vicinity of the optical axis AX of the charged particle optical system 4b may be referred to as an inner region or a first region, and a region of a peripheral portion may be referred to as an outer region or a second region. The inner region and the outer region (the first region and the second region) may be regions in a plane perpendicular to the optical axis AX.

Here, in the plane perpendicular to the optical axis AX, the region where the current density is larger than the vicinity of the optical axis AX may have a ring-belt shape centered on the optical axis AX, or may have a multipolar shape.

Then, the charged particle beam PP, which has been transformed into a hollow beam, is focused by the second lens part 13 and irradiated onto the target object 22.

Here, the charged particle beam PP irradiated onto the target object 22 has a smaller space electric charge effect than a charged particle beam (solid beam, for example, a Gauss beam) that is not made into a hollow beam, so its focal range is reduced (the blur of image is reduced). That is, a beam spot size on the target object 22 by the charged particle beam PP can be reduced.

Here, it can be said that the condenser lens part 26 has the function of increasing the current density distribution on or near the pupil surface of the charged particle optical system 4b in a region far from the optical axis AX compared to the region including the optical axis AX. In addition, it can be said that the condenser lens part 26 has the function of increasing the current density distribution in the plane perpendicular to the optical axis in the second lens part 13 in a region that is far from the optical axis AX compared to the region including the optical axis AX.

Conversion of increasing the current density distribution in the plane perpendicular to the optical axis AX of the charged particle optical system 4b in the region far from the optical axis AX compared to the region including the optical axis AX may include making the current density in the vicinity of the optical axis AX of the charged particle beam PP before conversion (before entering the condenser lens part 26) smaller than the current density in the vicinity of the optical axis AX of the charged particle beam PP after conversion (after emitting from the condenser lens part 26). In addition, it may also include making the current density in the peripheral portion of the charged particle beam PP before conversion (before entering the condenser lens part 26) larger than the current density in the peripheral portion of the charged particle beam PP after conversion (after emitting from the condenser lens part 26).

Next, the arrange condition of the above-mentioned condenser lens part 26 will be described in detail.

The condenser lens part 26 may be disposed such that at least a part is positioned between a position of the aperture member 9 (a position of a beam waist) and a position separated from the position of the aperture member 9 (the position of the beam waist) by a distance L in the optical axis AX direction.

Provided that a perveance of the charged particle optical system is P and a beam radius of the charged particle beam at the first position is Rm, the distance L is expressed by:

[Math. 1]

$$L = \frac{10.9 \times 10^{-3}}{\sqrt{P}} \times Rm$$

Here, provided that a beam current [A] is I, and an average electric potential [V] of the beam is V, the perveance P is expressed by:

[Math. 2]

$$P = \frac{I}{V^{\frac{3}{2}}} \left[ A \middle/ V^{\frac{3}{2}} \right]$$

When the condenser lens part 26 satisfies this arrangement condition, the condenser lens part 26 can effectively accomplish beam hollowing of the charged particle beam PP.

Next, another arrangement condition will be described.

In the third embodiment, since the charged particle beam PP passing through the aperture member 9 becomes a divergence state with respect to the optical axis AX and heads toward the condenser lens part 26, the size of the cross section of the charged particle beam PP (the cross section crossing the optical axis AX, typically, the cross section crossing the optical axis AX) is increased as it gets away from the aperture member 9.

Here, the size of the cross section of the charged particle beam PP increases non-linearly as it gets away from the aperture member 9 (beam waist), and then turns to a linear increase.

Here, the end portion of the condenser lens part 26 on the side closer to the aperture member 9 (on the side of the beam waist) in the optical axis AX direction may be closer to the aperture member 9 (the beam waist) than a position where an increase in size of the charged particle beam PP is turned to a linear increase, or may be closer to the aperture member 9 (the beam waist) than a position where a curvature κ of the change in the increasing rate of the size of the charged particle beam PP becomes a maximum curvature. Here, the change in the increasing rate of the size of the charged particle beam PP may be calculated without the effect by the condenser lens part 26.

Further, the curvature κ of the change in the increasing rate of the charged particle beam PP is expressed by

[Math. 3]

$$\kappa = \frac{f''(x)}{\left( 1 + \left( f'(x) \right)^2 \right)^{\frac{3}{2}}}$$

provided that
κ: curvature
f'(x): first-order differentiation of change in increasing rate of size of charged particle beam PP
f'(x): second-order differentiation of change in increasing rate of size of charged particle beam PP.

Here, the size of the charged particle beam PP may be the size of the charged particle beam PP in the cross section crossing (typically, perpendicular to) the optical axis AX direction, for example, a beam diameter. Further, the size of the charged particle beam PP may be based on the size at the position of the aperture member 9 (the position of the beam waist) (the increasing rate based on the size at the position of the aperture member 9 (the position of the beam waist) can also be seen).

When the condenser lens part 26 satisfies this arrange condition, the condenser lens part 26 can effectively accomplish beam hollowing of the charged particle beam PP.

The above-mentioned two arrange conditions may be simultaneously satisfied or one of them may be satisfied.

Further, in the following description, while the case in which the beam waist is formed at the position of the aperture member 9 has been described, the beam waist may be formed in the vicinity of the charged particle beam source 1. In this case, the position of the aperture member 9 in the above-mentioned two arrange conditions may be read as the position of the charged particle beam source 1 and/or the position of the beam waist.

(Effects of charged particle optical system and charged particle apparatus of third embodiment)

(6) The charged particle optical system 4b of the third embodiment is a charged particle optical system configured to converge the charged particle beams PP, which is emitted from the charged particle beam source 3, to the object (the target object 22), and includes a first electron optical system 26 configured to control a current density distribution of the charged particle beam PP, and a second electron optical system 13 configured to converge the charged particle beams PP from the first electron optical system 26 to the target object 22. Then, the first electron optical system 26 provides a magnetic field to charged particle beam passing through the first electron optical system 26 so that the current density distribution of the charged particle beam entering the second electron optical system 13 in a plane perpendicular to the optical axis AX is increased in the second region outside the first region including the optical axis AX.

According to this configuration, the first electron optical system 26 can make the charged particle beam PP heading to the second electron optical system 13 and the charged particle beam PP converged to the object into a hollow beam, and can reduce an increase in beam spot size caused by the space electric charge effect in the object. Accordingly, the charged particle optical system 4 of the third embodiment can achieve high resolution.

Further, in the charged particle optical system 4 having the above-mentioned effects, at least some of the first lens part 5, the aperture member 9, the detection part 6, the electric charge measuring instrument 8, and the insulating member 7, which are above-mentioned, do not necessarily have to be provided.

As described above, while the various embodiments have been described, the present invention is not limited to these contents. In addition, the embodiments may be applied individually or in combination. Other aspects that can be considered within the scope of the technical spirit of the present invention are also included within the scope of the present invention.

(Supplementary Statements)

It will be understood by those skilled in the art that the plurality of embodiments or their variants described above are specific examples of the following aspects.

(Aspect 1)

A charged particle apparatus including:
a plurality of magnetic detector disposed along an optical axis of a charged particle optical system configured to converge charged particle beams, which is emitted from a charged particle beam source, to an object, and a calculation part configured to calculate information related to the charged particle beams flowing through the optical axis and the vicinity of the optical axis on the basis of detection values of the plurality of magnetic detectors.

(Aspect 2)

The charged particle apparatus according to aspect 1, wherein at least some of the plurality of magnetic detectors are disposed at different positions in an optical axis direction.

(Aspect 3)

The charged particle apparatus according to aspect 1 or 2, wherein the calculation part calculates information related to a charged particle density distribution of the charged particle beam in a direction crossing the optical axis, and information related to a deviation angle from the optical axis in a direction of advance of the charged particle beam.

(Aspect 4)

The charged particle apparatus according to any one of aspects 1 to 3, wherein the magnetic detector is a magneto-impedance element.

(Aspect 5)

The charged particle apparatus according to any one of aspects 1 to 4, wherein a magnetic material having a relative permeability of two or more is not disposed within a range five times the distance from the optical axis to the magnetic detector about each of the plurality of magnetic detectors.

(Aspect 6)

The charged particle apparatus according to any one of aspects 1 to 5, wherein a controller configured to control the charged particle beam source and emit charged particles in pulses at a predetermined frequency is provided, and the calculation part calculates information related to the charged particle beam on the basis of an element in synchronization with the predetermined frequency in the detection values.

(Aspect 7)

A charged particle optical system configured to converge charged particle beams, which is emitted from a charged particle beam source, to an object, the charged particle optical system including: an aperture member provided between a space that has an opening through which the charged particle beam is able to pass and that is disposed closer to the charged particle beam source than the opening; and a detection part that is disposed closer to the charged particle beam source than the aperture member and that is configured to detect an electron from the aperture member through which the charged particle beam is irradiated.

(Aspect 8)

The charged particle optical system according to aspect 7, including a first exhaust system configured to exhaust a space closer to the charged particle beam source than the aperture member, and a second exhaust system configured to exhaust a space opposite to the space closer to the charged particle beam source than the aperture member.

(Aspect 9)

The charged particle optical system according to aspect 8, wherein an atmospheric pressure in the space closer to the charged particle beam source than the aperture member is smaller than an atmospheric pressure in the space opposite to the space closer to the charged particle beam source than the aperture member.

(Aspect 10)

The charged particle optical system according to any one of aspects 7 to 9, including an insulating member configured to cover the detection part against the charged particle beam and electrically separate the detection part and the aperture member.

(Aspect 11)

The charged particle optical system according to any one of aspects 7 to 10, wherein a deflection part that is disposed closer to the charged particle beam source than the aperture member and that is configured to shift a position of the charged particle beam with respect to the opening of the aperture member.

(Aspect 12)

The charged particle optical system according to any one of aspects 7 to 11, wherein the aperture member includes a supply system having a flow channel and configured to supply a temperature-adjusted fluid to the flow channel.

(Aspect 13)

A charged particle apparatus having a plurality of charged particle optical systems according to aspect 12, wherein the plurality of charged particle optical systems are arranged in a first direction crossing an optical axis direction of the charged particle optical system, and the flow channel of the aperture member of each of the plurality of charged particle optical systems is supplied with a fluid in a direction crossing the first direction.

(Aspect 14)

A charged particle optical system configured to converge charged particle beams, which is emitted from a charged particle beam source, to an object, the charged particle optical system comprising:

a first electron optical system configured to control a current density distribution of the charged particle beam; and

a second electron optical system configured to converge charged particle beams from the first electron optical system to the object, wherein at least a part of the first electron optical system is located between a first position, which is a position of a beam waist of the charged particle beam emitted from the charged particle beam source, and a second position, which is separated from the beam waist by the distance L, in an optical axis direction of the charged particle optical system, wherein the distance L satisfies the following equation,

[Math. 4]

$$L = \frac{10.9 \times 10^{-3}}{\sqrt{P}} \times Rm$$

provided that a perveance of the charged particle optical system is P, and a beam radius of the charged particle beam at the first position is Rm, the perveance is expressed by the following equation,

[Math. 5]

$$P = \frac{I}{V^{\frac{3}{2}}} \left[ A \middle/ V^{\frac{3}{2}} \right]$$

provided that a beam current [A] is I, and an average electric potential [V] of a beam is V

(Aspect 15)

The charged particle optical system according to aspect 14, wherein the first electron optical system provides a magnetic field to a charged particle beam passing through the first electron optical system such that a current density distribution in a plane perpendicular to the optical axis of the charged particle beam entering the second electron optical system is increased in an outer region which is outside of an inner region including the optical axis.

[Reference Signs List]

1, 1a: charged particle apparatus, 2: lens barrel, 25: chamber, 3: charged particle beam source, 4: charged particle optical system, AX: optical axis, PP:

charged particle beam, 5: first lens part, 5a: first magnetic lens, 5b: first deflection part, 6: detection part, 7: insulating member, 8: electric charge measuring instrument, 9: aperture member, 10: flow channel, 11: supply system, 12: magnetic detector, 13: second lens part, 14: permanent magnetic lens, 14a, 14b: permanent magnet (first compound lens), 15: electromagnetic lens, 15a, 15b: electromagnet (second compound lens), 16: electrostatic lens, 17: conductive film, 19: second deflection part, 22: target object, 23: sampling stage, Vc1 to Vc3: exhaust system, A1: first region, A2: second region, A3: third region

**Claims**

1. A charged particle optical system configured to converge charged particle beams, which is emitted from a charged particle beam source, to an object, the charged particle optical system comprising:

   a permanent magnetic lens disposed closer to the object than a central point between the charged particle beam source and the object in an optical axis direction of the charged particle optical system;
   an electromagnetic lens disposed such that a position of at least a part of the electromagnetic lens overlaps the permanent magnetic lens in the optical axis direction of the charged particle optical system; and
   an electrostatic lens disposed such that a position of at least a part of the electrostatic lens overlaps at least one of the permanent magnetic lens and the electromagnetic lens in the optical axis direction of the charged particle optical system.

2. The charged particle optical system according to claim 1, wherein the charged particle beams diverge with respect to an optical axis of the charged particle optical system at a side closer to the charged particle beam source than the permanent magnetic lens, and wherein the permanent magnetic lens converges the charged particle beams with respect to the optical axis of the charged particle optical system at the side closer to the obj ect.

3. The charged particle optical system according to claim 1 or 2, wherein the permanent magnetic lens is disposed in a vicinity of a pupil surface of the charged particle optical system.

4. The charged particle optical system according to any one of claims 1 to 3, wherein at least one of the permanent magnetic lens and the electromagnetic lens is disposed at a position farther from the optical axis of the charged particle optical system than the electrostatic lens.

5. The charged particle optical system according to any one of claims 1 to 4, wherein the electromagnetic lens comprises a plurality of electromagnets that are arranged in the optical axis direction of the charged particle optical system and in which directions of magnetic fields of the plurality of electromagnets are opposite to each other in the optical axis direction of the charged particle beam.

6. The charged particle optical system according to any one of claims 1 to 5, wherein the permanent magnetic lens comprises a plurality of permanent magnets that are arranged in the optical axis direction of the charged particle optical system and in which directions of magnetic fields of the plurality of permanent magnets are opposite to each other in the optical axis direction of the charged particle beam.

7. The charged particle optical system according to claim 6, wherein the electromagnetic lens is disposed between two of the plurality of permanent magnets included in the permanent magnetic lens in the optical axis direction of the charged particle optical system.

8. The charged particle optical system according to any one of claims 1 to 7, wherein the permanent magnetic lens is a first compound lens comprising a plurality of permanent magnets in which directions of generated magnetic fields of the plurality of permanent magnets are opposite to each other,

   wherein the electromagnetic lens is a second compound lens including a plurality of coils in which directions of generated magnetic fields of the plurality of coils are opposite to each other, and
   wherein a center of the second compound lens coincides with a center of the first compound lens.

9. The charged particle optical system according to claim 8, wherein the electrostatic lens is disposed closer to the object than the center of the second compound lens in the optical axis direction of the charged particle optical system.

10. The charged particle optical system according to any one of claims 1 to 9, wherein the permanent magnetic lens forms a magnetic field parallel to the optical axis of the charged particle optical system in a first region,

    wherein the electromagnetic lens forms a magnetic field parallel to the optical axis of the charged particle optical system in a second region,

wherein the electrostatic lens forms an electrostatic lens field coaxial with the optical axis of the charged particle optical system in a third region, and

wherein at least some of the first region, the second region, and the third region overlap each other in the optical axis direction of the charged particle optical system.

11. A charged particle optical system configured to converge charged particle beams, which is emitted from a charged particle beam source, to an object, the charged particle optical system comprising:

a permanent magnetic lens configured to form a magnetic field parallel to an optical axis of the charged particle optical system in a first region;

an electromagnetic lens configured to form a magnetic field parallel to the optical axis of the charged particle optical system in a second region; and

an electrostatic lens configured to form an electrostatic lens field coaxial with the optical axis of the charged particle optical system in a third region,

wherein at least some of the first region, the second region, and the third region overlap each other in an optical axis direction of the charged particle optical system.

12. The charged particle optical system according to claim 10 or 11, wherein the electromagnetic lens controls the magnetic fields in the region overlapping each other and makes that a position of the object irradiated with the charged particle beam is positioned within a focus depth of the charged particle beam.

13. The charged particle optical system according to any one of claims 1 to 12, wherein the electrostatic lens comprises an electrode including a columnar internal space which is substantially parallel to the optical axis of the charged particle optical system and in which a center of the columnar internal space is substantially coinciding with the optical axis, and a ratio between a length in the optical axis direction and an inner diameter of the internal space of the electrode is 1.67 or more.

14. The charged particle optical system according to any one of claims 1 to 13, comprising a deflector configured to deflect the charged particle beam and change a position in the object where the object is irradiated with the charged particle beam in a direction crossing the optical axis of the charged particle optical system,

wherein the deflector is disposed closer to the object than the electrostatic lens in the optical axis direction of the charged particle optical system.

15. The charged particle optical system according to claim 14, wherein a conductive film disposed between the deflector and the electrostatic lens is provided.

16. A charged particle apparatus comprising:

the charged particle optical system according to claim 14 or 15, and

a controller configured to control the electromagnetic lens, the electrostatic lens and the deflector,

wherein the deflector is able to change a position in the object where the object is irradiated with the charged particle beam in a first direction and a second direction that cross the optical axis,

wherein the controller changes a focus of the charged particle beam by the electromagnetic lens according to a distance in which the position in the object where the object is irradiated with the charged particle beam is changed in the first direction, and

wherein the controller changes the focus of the charged particle beam by the electrostatic lens according to a distance in which the position in the object where the object is irradiated with the charged particle beam is changed in the second direction, and

wherein the distance in which the position in the object where the object is irradiated with the charged particle beam is changed in the first direction is greater than the distance in which the position in the object where the object is irradiated with the charged particle beam is changed in the second direction.

17. The charged particle optical system according to any one of claims 1 to 15, further comprising a condenser optical system that is disposed between the charged particle beam source and the permanent magnetic lens and that is configured to provide a magnetic field to a passing charged particle beam so that a current density distribution in a plane perpendicular to the optical axis of the charged particle beam entering the permanent magnetic lens becomes greater in an outer region which is outside of an inner region including the optical axis.

18. The charged particle optical system according to claim 17, further comprising an aperture member disposed between the charged particle beam source and the condenser optical system in the optical axis direction of the charged particle optical system,

wherein the charged particle beam passing through the aperture member has a size increased in a direction crossing the optical axis as it gets away from the aperture member in the optical axis direction, and

a non-linear increase region in which an increase in the size of the charged particle beam non-linearly increases and the condenser optical system at least partially overlap each other in the optical axis direction.

19. The charged particle optical system according to claim 18, wherein an end point of the non-linear increase region at a side closer to the object in the optical axis direction is a point where a change in increasing rate of the size of the charged particle beam has a maximum curvature.

20. The charged particle optical system according to claim 18 or 19, wherein an end point of the non-linear increase region at a side closer to the object in the optical axis direction satisfies the following equation,

[Math. 1]

$$L = \frac{10.9 \times 10^{-3}}{\sqrt{P}} \times Rm$$

provided that a distance from the aperture member in the optical axis direction is L, a perveance of the charged particle optical system is P, and a beam radius of the charged particle beam at a position of the aperture member is Rm, and the perveance is expressed by the following equation,

[Math. 2]

$$P = \frac{I}{V^{\frac{3}{2}}} \left[ A \middle/ V^{\frac{3}{2}} \right]$$

provided that a beam current [A] is I, and an average electric potential [V] of the beam is V.

21. A charged particle optical system configured to converge charged particle beams, which is emitted from a charged particle beam source, to an object, the charged particle optical system comprising:

a first electron optical system configured to control a current density distribution of the charged particle beam; and
a second electron optical system configured to converge charged particle beams from the first electron optical system to the object,
wherein the first electron optical system provides a magnetic field to charged particle beam passing through the first electron optical system so that a current density distribution of the charged particle beam entering the second electron optical system in a plane perpendicular to the optical axis is increased in an outer region which is outside of an inner region including the optical axis.

22. The charged particle optical system according to claim 20, wherein the charged particle beam passing through the first electron optical system receives an exchange action of the current density distribution due to a primary convergence action by the first electron optical system and a space electric charge effect of the charged particle beam.

23. The charged particle optical system according to claim 20 or 21, wherein the outer region has a ring-belt shape about the optical axis.

24. The charged particle optical system according to any one of claims 20 to 23, further comprising an aperture member disposed between the charged particle beam source and the first electron optical system in the optical axis direction of the charged particle optical system,

wherein the charged particle beam passing through the aperture member has a size increased in a direction crossing the optical axis away from the aperture member in the optical axis direction, and
a non-linear increase region where an increase in the size of the charged particle beam is non-linearly increased and the first electron optical system at least partially overlap each other in the optical axis direction.

25. The charged particle optical system according to claim 24, wherein an end point of the non-linear increase region at a side closer to the object in the optical axis direction satisfies the following equation,

[Math. 3]

$$L = \frac{10.9 \times 10^{-3}}{\sqrt{P}} \times Rm$$

provided that a distance from the aperture member in the optical axis direction is L, a perveance of the charged particle optical system is P, and a beam radius of the charged particle beam at the position of the aperture member is Rm, and the perveance is expressed by the following equation,

[Math. 4]

$$P = \frac{I}{V^{\frac{3}{2}}} \left[ A \middle/ V^{\frac{3}{2}} \right]$$

provided that a beam current [A] is I, and an average electric potential [V] of the beam is V.

26. The charged particle optical system according to claim 24 or 25, wherein an end point of the non-linear increase region at a side closer to the object in the optical axis direction is a point where a change in increasing rate of the size of the charged particle beam has a maximum curvature.

# FIG. 1

FIG. 2

FIG. 3

# FIG. 4

FIG. 5

<u>1a</u>

2

4

10i

9

10o

22

25

23

Z
Y
X

FIG. 6

EP 4 333 017 A1

24

## INTERNATIONAL SEARCH REPORT

| International application No. |
| --- |
| **PCT/JP2022/018129** |

**A. CLASSIFICATION OF SUBJECT MATTER**

*H01J 37/143*(2006.01)i; *H01J 37/145*(2006.01)i
FI: H01J37/143; H01J37/145

According to International Patent Classification (IPC) or to both national classification and IPC

**B. FIELDS SEARCHED**

Minimum documentation searched (classification system followed by classification symbols)

H01J37/143; H01J37/145

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 59-14242 A (HITACHI LTD) 25 January 1984 (1984-01-25)<br>fig. 1; p. 1, lower right column, line 14 to p. 2, upper left column, line 3, p. 2, upper left column, line 18 to p. 2, upper right column, line 6 | 1-4, 10-17, 21-23 |
| A | | 5-9 |
| Y | US 2020/0161079 A1 (ASML NETHERLANDS B.V.) 21 May 2020 (2020-05-21)<br>fig. 2B, 3A; paragraphs [0073], [0075], [0079]-[0081] | 1-4, 10-17 |
| Y | YURI, Yosuke et al. Formation of hollow ion beams of various shapes using multipole magnets. Progress of Theoretical and Experimental Physics. 11 May 2019, vol. 2019, issue 5, 053G01, https://doi.org/10.1093/ptep/ptz024, title<br>title | 17, 21-23 |
| A | | 18-20, 24-26 |
| A | WO 2012/057166 A1 (PARAM CORPORATION) 03 May 2012 (2012-05-03)<br>fig. 1; paragraphs [0023], [0041] | 5-9 |

☐ Further documents are listed in the continuation of Box C. ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **24 June 2022** | **05 July 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

International application No.

**PCT/JP2022/018129**

**Box No. III    Observations where unity of invention is lacking (Continuation of item 3 of first sheet)**

This International Searching Authority found multiple inventions in this international application, as follows:

Claim 1 and claim 21 are common only in the feature of an electronic lens which is merely the obvious the prior art.

On the premise of the common feature, in the former, it is characterized that an electrostatic lens is added to an electronic lens composed of a permanent magnet lens and an electromagnetic lens in order to make response rapid, and the latter relates to a device of an electrooptic system to increase the occurrence rate of hollow beams.

As the result, claims 1-20 and claims 21-26 do not have the same or corresponding "special technical feature" indicated in PCT Rule 13.2, the "special technical feature" being a technical feature that defines a contribution made over the prior art.

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**      ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (January 2015)

## INTERNATIONAL SEARCH REPORT
### Information on patent family members

International application No.

**PCT/JP2022/018129**

| Patent document cited in search report | | | Publication date (day/month/year) | Patent family member(s) | | | Publication date (day/month/year) |
|---|---|---|---|---|---|---|---|
| JP | 59-14242 | A | 25 January 1984 | (Family: none) | | | |
| US | 2020/0161079 | A1 | 21 May 2020 | JP | 2022-506149 | A | |
| | | | | CN | 113056806 | A | |
| | | | | KR | 10-2021-0075184 | A | |
| | | | | TW | 202034367 | A | |
| WO | 2012/057166 | A1 | 03 May 2012 | US | 2013/0134322 | A1 | |
| | | | | fig. 1; paragraphs [0023], [0056] | | | |
| | | | | TW | 201225144 | A | |
| | | | | CN | 103038855 | A | |
| | | | | KR | 10-2013-0138713 | A | |

Form PCT/ISA/210 (patent family annex) (January 2015)

27

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021075751 A

- US 9472372 B